# EUROPEAN PATENT APPLICATION

(11) **EP 3 462 505 A1**
(43) Date of publication of application: **03.04.2019**
(21) Application number: 18196166.5
(22) Date of filing: 24.09.2018
(51) Int. Cl.: H01L 31/05, H01L 31/044

(54) **PHOTOVOLTAIC ASSEMBLY**

(30) Priority: 27.09.2017 CN 201721253462 U
(71) Applicant: Beijing Juntai Innovation Technology Co., Ltd, 100176 Beijing (CN)
(72) Inventor: YU, Cao, Beijing, Beijing 100176 (CN); LONG, Yongdeng, Beijing, Beijing 100176 (CN); HU, Dezheng, Beijing, Beijing 100176 (CN); LI, Yuanmin, Beijing, Beijing 100176 (CN)
(74) Representative: Nony

(57) **Abstract**

A photovoltaic assembly is provided, which includes a plurality of solar cells; a plurality of lead wires, the solar cells are connected in series through the lead wires; a plurality of diodes, each of the solar cells is connected in parallel with one of the diodes, or a specified number of adjacent ones of the solar cells as a whole is connected in parallel with one of the diodes; and a packaging structure, and the solar cells, the lead wires and the diodes are arranged in the packaging structure.

## Description

### TECHNICAL FIELD

The present disclosure relates to the technical field of solar cells, and for example to a photovoltaic assembly.

### BACKGROUND

A solar cell, which is also called a "solar chip" or a "photovoltaic cell", is a photoelectric semiconductor slice capable of directly generating power by using the sunlight. The solar cell can instantly output a voltage and generate a current in the presence of a return circuit once it is irradiated by light that meets a certain illuminance condition. A principle that the solar cell generates the current is that the sunlight irradiates a p-n junction of a semiconductor to form new hole-electron pairs, and under the action of a built-in electric field of the p-n junction, a photogenerated hole flows to a region p, and photo-induced electrons flow to a region n, so as to turn on a circuit, thereby generating the current.

A photovoltaic assembly includes a plurality of serially connected cell strings. Each cell string includes a plurality of serially connected cells. A description is made by taking a photovoltaic assembly including sixty cells as an example. The photovoltaic assembly generally includes six cell strings, and each cell string includes ten solar cells. Generally, the six cell strings are connected in series together, and then are connected with an external junction box, or every two cell strings are connected in series together, and then are connected with an external junction box. The junction box is generally arranged outside a laminated plate of the photovoltaic assembly to connect the cell strings with an external circuit. The inside of the junction box includes a bypass diode. When any one of the cells in the cell strings connected in parallel with the bypass diode is split and the like, it is equivalent that all the cell strings connected in parallel with the bypass diode are broken inside, resulting in a failure, thereby generating a great impact on the power generation efficiency of the photovoltaic assembly. However, cost and process difficulty may also be increased if each cell is equipped with one bypass diode by means of the junction box.

### SUMMARY

The present disclosure provides a photovoltaic assembly capable of solving a problem that the cost and the process difficulty may be increased if each solar cell is equipped with one bypass diode by means of the junction box in a related art.

A photovoltaic assembly includes a plurality of solar cells; a plurality of lead wires, the plurality of solar cells are connected in series through the lead wires; a plurality of diodes, each of the plurality of solar cells is connected in parallel with one of the plurality of diodes, or a specified number of adjacent ones of the plurality of solar cells as a whole is connected in parallel with one of the plurality of diodes; and a packaging structure, the plurality of solar cells. The plurality of lead wires and the plurality of diodes are arranged in the packaging structure.

In an embodiment, each of the plurality of diodes includes a PN junction, a positive lead and a negative lead. A first end of the positive lead is connected to an anode of one of the plurality of solar cells, and a second end of the positive lead is connected to an anode of the PN junction; a first end of the negative lead is connected to a cathode of the one of the plurality of solar cells, and a second end of the negative lead is connected to a cathode of the PN junction.

In an embodiment, the plurality of solar cells include at least one type of the following solar cells: hetero-junction solar cells, polycrystalline silicon solar cells and monocrystalline silicon solar cells.

In an embodiment, the hetero-junction solar cells include amorphous silicon/monocrystalline silicon hetero-junction solar cells.

In an embodiment, the plurality of lead wires are ribbons; and the solar cells are soldered with the ribbons.

In an embodiment, the positive lead and the negative lead are a tin-coated copper piece.

In an embodiment, the tin-coated copper piece is 0.5 to 5 mm in width and 0.01 to 0.4 mm in thickness.

In an embodiment, the plurality of solar cells include a first solar cell and a second solar cell adjacent to each other, the first solar cell and the second solar cell as a whole is connected in parallel with one of the plurality of diodes; and the positive lead is soldered on the ribbon on a back surface of the first solar cell, and the negative lead is soldered on the ribbon on a back surface of the second solar cell.

In an embodiment, the positive lead is soldered on one ribbon of the first solar cell, and the negative lead is soldered on one ribbon of the second solar cell.

In an embodiment, a surface area of the PN junction is N mm²; N is greater than 0 and less than or equal to 9; and the PN junction is located in a gap between two adjacent ones of the plurality of solar cells.

In an embodiment, further including an insulating layer arranged between the solar cells and the PN junction.

In an embodiment, the packaging structure includes from a first side to a second side in sequence: a glass layer, a first solar cell packaging adhesive film, a second solar cell packaging adhesive film and a back plate layer, the plurality of solar cells, the plurality of lead wires and the plurality of diodes are arranged between the first solar cell packaging adhesive film and the second solar cell packaging adhesive film.

In an embodiment, at least one of the first solar cell packaging adhesive film and the second solar cell packaging adhesive film is an ethylene-vinyl acetate copolymer EVA or a polyvinyl butyral PVB.

In an embodiment, the plurality of solar cells includes a plurality of first solar cells disposed in an edge region of the photovoltaic assembly, and a plurality of second solar cells disposed in a non-edge region of the photovoltaic assembly; and each of the plurality of first solar cells is connected in parallel with one of the plurality of diodes, and a specified number of adjacent ones of the plurality of second solar cells as a whole is connected in parallel with one of the plurality of the diodes.

The photovoltaic assembly provided by the present disclosure achieves that each of the solar cells is equipped with one bypass diode. Furthermore, since the PN junctions are extremely thin, the thickness of the photovoltaic assembly will not be increased, and the cost and the process difficulty will not be increased either. Furthermore, when one specific solar cell fails, the bypass diode will be short-circuited, so that the failed solar cell instead of a whole string of solar cells will be short-circuited, thereby contributing to improving the power generation efficiency.

### BRIEF DESCRIPTION OF DRAWINGS

FIG. 1 is a first structural schematic diagram illustrating a photovoltaic assembly provided according to an embodiment;
FIG. 2 is a second structural schematic diagram illustrating a photovoltaic assembly provided according to another embodiment; and
FIG. 3 is a third structural schematic diagram illustrating a photovoltaic assembly provided according to another embodiment.

### List of Reference Numerals:

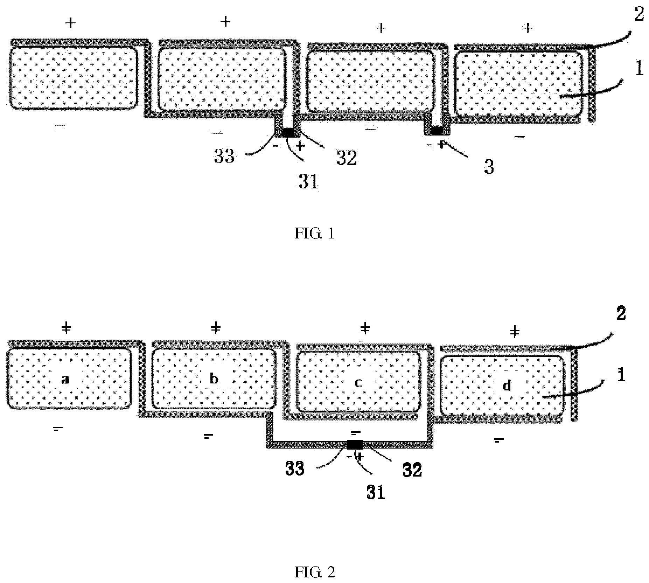

in the FIG. 1-FIG. 3:

| | |
|---|---|
| 1: solar cell | 31: PN junction |
| 2: lead wire | 32: positive lead |
| 3: diode | 33: negative lead |
| 34: insulating layer | 301: glass layer |
| 302: first EVA layer | 303: second EVA layer |
| 304: back plate layer | |

### DETAILED DESCRIPTION

FIG. 1 shows a first structural schematic diagram illustrating a photovoltaic assembly provided according to an embodiment.

In the present embodiment, the photovoltaic assembly may include a plurality of solar cells 1, a plurality of lead wires 2, a plurality of diodes 3 and a packaging structure. The plurality of solar cells 1 are connected in series through the lead wires 2. A first end of each of the lead wires 2 is connected to an anode of one of the solar cells 1, and a second end of the each of lead wires is connected with a cathode of another one of the solar cells 1. Each of the solar cells 1 is connected in parallel with one of the diodes 3. The solar cells 1, the lead wires 2 and the diodes 3 are arranged in the packaging structure. Each of the diodes 3 includes a PN junction 31, a positive lead 32 and a negative lead 33. Different types of the PN junctions 31 may be selected according to demands of actual use. For example, the PN junctions are selected to adapt to a thickness close to substrates of the solar cells 1, or common types of PN junctions 31 on the market are directly adopted to avoid increasing an accommodating space after connecting the PN junctions 31. The PN junctions 31 have a small size, so that a required accommodating space is relatively small. A first end of the positive lead 32 is connected to an anode of one of the solar cells 1, and a second end of the positive lead 32 is connected to an anode of one of the PN junctions 31. A first end of the negative lead 33 is connected to a cathode of the one of the solar cells 1, and a second end of the negative leads 33 is connected to a cathode of the PN junction 31. The number of the solar cells 1 may be set according to an output voltage of the designed photovoltaic assembly. For example, if the output voltage of a single one of the solar cells 1 is 0.5 V, and the output voltage of the designed photovoltaic assembly is 5 V, ten solar cells are connected in series. The number of the diodes 3 may be set according to the design. For example, it needs to implement that: since each of the solar cells 1 is connected in parallel with one of the diodes 3, after one of the solar cells 1 fails, only this one of the solar cells 1 is short-circuited, and other solar cells 1 still can stably output voltages.

The solar cells 1 may include any one or more types of the following solar cells: hetero-junction solar cells, polycrystalline silicon solar cells and monocrystalline silicon solar cells. The most important parameter for solar cells is conversion efficiency. In silicon-based solar cells researched and developed in a laboratory, a monocrystalline silicon solar cell has an efficiency of 25.0%, a polycrystalline silicon solar cell has an efficiency of 20.4%, a copper indium gallium selenide (CIGS) thin film solar cell has an efficiency of 19.6%, a cadmium telluride (CdTe) thin film solar cell has an efficiency of 16.7%, and a noncrystalline silicon (amorphous silicon) thin film solar cell has an efficiency of 10.1%. In an embodiment, the hetero-junction solar cells are an amorphous/monocrystalline silicon (a-Si/c-Si) hetero-junction (SHJ) solar cell. The SHJ solar cell is a hybrid solar cell made of crystalline silicon thin film and amorphous silicon thin film, has the features of low preparation process temperature, high conversion efficiency, good high-temperature resistant characteristic and the like, and is a low-price high-efficiency solar cell. The conversion efficiency in a laboratory state of the solar cell has reached 23%, and theoretical analysis shows that the conversion efficiency of the solar cell structure may exceed 25%.

In an embodiment, when each of the solar cells 1 is connected in parallel with one of the diodes 3, a forward conduction voltage of each of the PN junctions 31 should be higher than a voltage output by the single one of the solar cells 1. For example, if the output voltage of the one of the solar cells 1 is 0.6 V, the forward conduction voltage of the each of the PN junctions 31 is 0.7 V.

In an embodiment, the lead wires 2 may be copper wires, aluminum wires or other lead wires, and also may be special ribbons and the like. In an embodiment, the lead wires 2 are ribbons. The solar cells 1 are soldered with the ribbons. The positive lead 32 and the negative lead 33 are a tin-coated copper piece. The tin-coated copper piece may be in a range of 0.5 to 5 mm in width and in a range of 0.01 to 0.4 mm in thickness.

In an embodiment, ten or twelve solar cells 1 are included in each solar cell string in the photovoltaic assembly. The tin-coated copper piece may be 3 mm in width and 0.3 mm in thickness. The positive lead 32 and the negative lead 33 are respectively soldered on ones of the ribbons on a back surface of two of the solar cells 1.

The photovoltaic assembly provided by the present embodiment includes the solar cells 1, the lead wires 2 and the diodes 3. The plurality of solar cells 1 are connected in series through the lead wires 2. Each of the solar cells 1 is connected in parallel with one of the diodes 3, or a specified number of adjacent ones of the solar cells 1 as a whole is connected in parallel with one of the diodes 3. The solar cells 1, the lead wires 2 and the diodes 3 are arranged in the packaging structure. Each of the diodes 3 includes the PN junction 31, the positive leads 32 and the negative leads 33. The first end of the positive lead 32 is connected to the anode of the one of the solar cells 1, and a second end of the positive lead 32 is connected to the anode of the one of the PN junctions 31. The first end of the negative lead 33 is connected to the cathode of the one of the solar cells 1, and the second end of the one of the negative leads 33 is connected to the cathode of the one of the PN junctions 31, thereby achieving that each of the solar cells 1 is equipped with one bypass diode. Furthermore, since the PN junctions 31 are extremely thin and relatively lower in cost, the thickness of the photovoltaic assembly will not be increased, and the cost and the process difficulty will not be increased either.

FIG. 2 shows a second structural schematic diagram illustrating a photovoltaic assembly provided according to the present embodiment. In the present embodiment, a plurality of adjacent ones of the solar cells are regarded as a whole and connected in parallel with one of the diodes 3. Advantages of doing this are to reduce the complexity of the photovoltaic assembly and effectively reduce the number of the diodes 3. For example, two adjacent ones of the solar cells 1 are regarded as a whole and connected in parallel with the one of the diodes 3. However, there are some disadvantages that short circuiting of a single failed solar cell 1 cannot be realized, and two of the solar cells 1 have to be short-circuited at the same time although maybe only one of the two of the solar cells 1 fails.

The present embodiment illustrates the two adjacent ones of solar cells 1 (i.e. a first solar cell and a second solar cell) as a whole are connected in parallel with the one of the diodes 3. In addition, four or more adjacent ones of the solar cells 1 may be regarded as a whole and connected in parallel with one of the diodes 3. No more details will be described herein. When a plurality of adjacent ones of the solar cells 1 are regarded as a whole and connected in parallel with the one of the diodes 3, a forward conduction voltage of the one of the PN junctions 31 should be higher than a voltage output by the whole composed of the plurality of adjacent ones of the solar cells 1.

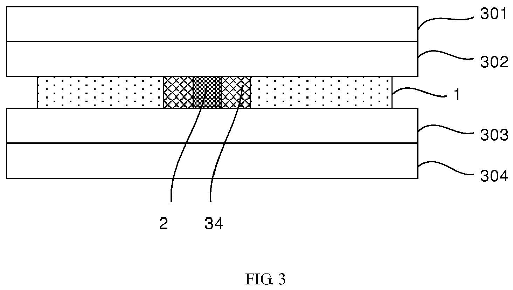

The positive lead 32 may be soldered on a ribbon on a back surface of the first solar cell, and the negative lead 33 may be soldered on a ribbon of the back surface of the second solar cell, or the positive lead 32 is soldered on the ribbon of one of the adjacent ones of the solar cells 1, and the negative lead 33 is soldered on the ribbon of another one of the adjacent ones of the solar cells 1. For example, there are four solar cells 1, such as a solar cell a, a solar cell b, a solar cell c and a solar cell d, as shown in FIG. 2. The positive lead 32 is soldered on a ribbon of an anode of the solar cell c, and the negative lead 33 is soldered on a ribbon of a cathode of the solar cell b. A PN junction 31 has a surface area of several square millimeters, and is located in a gap between two adjacent ones of the solar cells 1. The PN junction 31 has a small size, and occupies a small space, so that PN junction can be located in the gap between the two adjacent ones of the solar cells 1, and an extra space occupied by the bypass diode will be avoided. In addition, referring to FIG. 3, an insulating layer 34 is arranged between the solar cells 1 and the PN junction 31, so that a short-circuit phenomenon can be avoided. For example, a space between the solar cells 1 and the PN junction 31 is filled with resin and the like.

If the solar cells 1 are hetero-junction solar cells, since the hetero-junction solar cells are double-side luminous solar cells, a risk that the power generation efficiency is reduced by reduction of the areas of the solar cells 1 for receiving light due to the fact that the solar cells 1 are covered by the diodes may be avoided in the present embodiment.

In an embodiment, referring to FIG. 3, the packaging structure includes from the first side to the second side in sequence: a glass layer 301, a first ethylene-vinyl acetate copolymer (EVA) layer 302, a second EVA layer 303 and a back plate layer 304, the solar cells 1, the lead wires 2 and the diodes 3 are arranged between the first EVA layer 302 and the second EVA layer 303. In some embodiments, the first EVA layer 302 and the second EVA layer 303 may also be other solar cell packaging adhesive films, such as polyolefin elastomer (POE) films, or polyvinyl butyral (PVB) films and the like.

In an embodiment, the glass layer 301 may be toughened glass, and is functioned to protect a power generation main body (for example, the solar cell). Light transmittance requirements are as follows: 1. the light transmittance rate must be high (generally above 91%); and 2. ultra-white toughening treatment is performed. In addition, the surface of the toughened glass may be plated with a layer of anti-reflection film, such as a silicon dioxide thin film having a specified thickness and the like. The photovoltaic solar cell packaging adhesive film (including EVA) is configured to adhere and fix the toughened glass and the power generation main body (for example, the solar cell). The quality of a transparent adhesive film material directly affects the life of the assembly. The packaging adhesive film (for example, EVA or PVB and the like) exposed in air is easy to age and yellow, thereby affecting the light transmittance rate and the power generation quality of the assembly. In addition to the quality of the packaging adhesive film, a laminating process also has a great influence. For example, non-standard viscosity of the packaging adhesive film and insufficient strength of the packaging adhesive film and the toughened glass or the back plate both may lead to early aging of the packaging adhesive film and influence on the life of the assembly. The adhesive film is mainly used to adhere and package the power generation main body and the back plate layer. The back plate layer has main functions of sealing, insulation and waterproofing (TPT or TPE and the like are generally used. The material must be resistant to aging. A glass back plate is also acceptable). In addition, a framework, a sealant and the like may be also included. No more details will be described herein.

A photovoltaic assembly provided by an embodiment may include the above-mentioned first structure and second structure. Namely, in the photovoltaic assembly, each of one part of the plurality of solar cells 1 is connected in parallel with one of the diodes 3, and in the other part of the plurality of solar cells 1, each specified number of adjacent solar cells 1 as a whole is connected in parallel with one of the diodes 3.

In an embodiment, each of the solar cells 1 located in an edge region of the photovoltaic assembly is connected in parallel with one of the diodes 3. A specified number of adjacent solar cells 1 located in a non-edge region as a whole and connected in parallel with one of the diodes 3. For example, every two, three or more solar cells 1 are connected in parallel with one of the diodes 3. According to the photovoltaic assembly provided by an embodiment, the solar cells are amorphous/monocrystalline silicon hetero-junction solar cells. Since the amorphous/monocrystalline silicon hetero-junction solar cells have the features of low temperature coefficient, high environmental stability, double-side power generation capacity and the like, an actual outdoor power generation amount of the solar cells is greater than that of a traditional crystalline silicon solar cell by about 25%, and the energy conversion efficiency is effectively improved.

According to the photovoltaic assembly provided by an embodiment, the lead wires are ribbons. The solar cells are soldered with the ribbons, so that the strength and reliability of connection are higher. The positive leads and the negative leads are the tin-coated copper piece, so that the connection resistance may be effectively reduced, and the lead wires are higher in stability.

According to the photovoltaic assembly provided by an embodiment, the positive leads and the negative leads are respectively soldered on the ribbons on the back surfaces of the two adjacent ones of the solar cells to effectively reduce an area of the front surfaces covered of the solar cells, thereby contributing to improving the photoelectric conversion efficiency. In addition, each of the PN junctions has a surface area of several square millimeters, and may be located in the gap between the two adjacent ones of the solar cells, so that an increase of the thickness of the photovoltaic assembly or an increase of the size of the solar cell can be avoided, and the integration level can be increased.

## Claims

1. A photovoltaic assembly, **characterized by** comprising:
a plurality of solar cells (1);
a plurality of lead wires (2), wherein the plurality of solar cells (1) are connected in series through the lead wires (2);
a plurality of diodes (3), wherein each of the plurality of solar cells (1) is connected in parallel with one of the plurality of diodes (3), or a specified number of adjacent ones of the plurality of solar cells (1) as a whole is connected in parallel with one of the plurality of diodes (3); and
a packaging structure, wherein the plurality of solar cells (1), the plurality of lead wires (2) and the plurality of diodes (3) are arranged in the packaging structure.

2. The photovoltaic assembly according to claim 1, wherein each of the plurality of diodes (3) comprises: a PN junction (31), a positive lead (32) and a negative lead (33);
wherein a first end of the positive lead (32) is connected to an anode of one of the plurality of solar cells (1), and a second end of the positive lead (32) is connected to an anode of the PN junction (31); a first end of the negative lead (33) is connected to a cathode of the one of the plurality of solar cells (1), and a second end of the negative lead (33) is connected to a cathode of the PN junction (31).

3. The photovoltaic assembly according to claim 1 or 2, wherein the plurality of solar cells (1) comprise at least one type of the following solar cells:
hetero-junction solar cells, polycrystalline silicon solar cells and monocrystalline silicon solar cells.

4. The photovoltaic assembly according to claim 3, wherein the hetero-junction solar cells comprise amorphous silicon/monocrystalline silicon hetero-junction solar cells.

5. The photovoltaic assembly according to claim 1 or 2, wherein the plurality of lead wires (2) are ribbons; and the solar cells (1) are soldered with the ribbons.

6. The photovoltaic assembly according to claim 5, wherein the positive lead (32) and the negative lead (33) are a tin-coated copper piece.

7. The photovoltaic assembly according to claim 6, wherein the tin-coated copper piece is 0.5 to 5 mm in width and 0.01 to 0.4 mm in thickness.

8. The photovoltaic assembly according to claim 6, wherein the plurality of solar cells comprise a first solar cell and a second solar cell adjacent to each other, the first solar cell and the second solar cell as a whole is connected in parallel with one of the plurality of diodes (3); and the positive lead (32) is soldered on the ribbon on a back surface of the first solar cell, and the negative lead (33) is soldered on the ribbon on a back surface of the second solar cell (1).

9. The photovoltaic assembly according to claim 6, wherein the positive lead (32) is soldered on one ribbon of the first solar cell, and the negative lead (33) is soldered on one ribbon of the second solar cell.

10. The photovoltaic assembly according to claim 9, wherein a surface area of the PN junction (31) is N mm²; N is greater than 0 and less than or equal to 9; and the PN junction is located in a gap between two adjacent ones of the plurality of solar cells (1).

11. The photovoltaic assembly according to claim 9, further comprising an insulating layer (34) arranged between the solar cells (1) and the PN junction (31).

12. The photovoltaic assembly according to any one of claims 1 to 11, wherein the packaging structure comprises from a first side to a second side in sequence:
a glass layer (301), a first solar cell packaging adhesive film (302), a second solar cell packaging adhesive film (303) and a back plate layer (304),
wherein the plurality of solar cells (1), the plurality of lead wires (2) and the plurality of diodes (3) are arranged between the first solar cell packaging adhesive film (302) and the second solar cell packaging adhesive film (303).

13. The photovoltaic assembly according to claim 12, wherein at least one of the first solar cell packaging adhesive film (302) and the second solar cell packaging adhesive film (303) is an ethylene-vinyl acetate copolymer, EVA or a polyvinyl butyral, PVB.

14. The photovoltaic assembly according to claim 1, wherein the plurality of solar cells (1) comprises a plurality of first solar cells disposed in an edge region of the photovoltaic assembly, and a plurality of second solar cells disposed in a non-edge region of the photovoltaic assembly; and
wherein each of the plurality of first solar cells is connected in parallel with one of the plurality of diodes (3), and a specified number of adjacent ones of the plurality of second solar cells as a whole is connected in parallel with one of the plurality of the diodes (3).
